# EUROPEAN PATENT APPLICATION

(11) **EP 4 087 126 A1**
(43) Date of publication of application: **09.11.2022**
(21) Application number: 20910855.4
(22) Date of filing: 06.05.2020
(51) Int. Cl.: H03H 3/02

(54) **SEMICONDUCTOR STRUCTURE HAVING STACKING UNIT, MANUFACTURING METHOD, AND ELECTRONIC DEVICE**

(30) Priority: 31.12.2019 CN 201911419083
(71) Applicant: Rofs Microsystem (Tianjin) Co., Ltd, Tianjin 300462 (CN)
(72) Inventor: ZHANG, Wei, Tianjin 300462 (CN); PANG, Wei, Tianjin 300072 (CN); ZHANG, Lanyue, Tianjin 300462 (CN); WEN, Pan, Tianjin 300462 (CN); ZHANG, Menglun, Tianjin 300072 (CN); YANG, Qingrui, Tianjin 300072 (CN)
(74) Representative: Ström & Gulliksson AB
(86) International application number: PCT/CN2020/088706
(87) International publication number: WO 2021/135009

(57) **Abstract**

The present disclosure relates to a semiconductor structure having a stacking unit. The semiconductor structure includes: a protective layer having an upper surface and a lower surface; a plurality of units, wherein the units are sequentially stacked on the lower surface of the protective layer along the thickness direction of the protective layer, each unit includes a substrate, a first accommodating space is defined between the substrate of an uppermost unit and the protective layer, a second accommodating space is defined between the substrates of the upper and lower units that are adjacently stacked, the substrate of at least one unit is provided with a chip, and the chip is located inside a corresponding accommodating space; and a plurality of conductive through holes, wherein each conductive through hole penetrates through the protective layer from the upper surface of the protective layer, and extends downwards along the thickness direction of the protective layer, so as to be electrically connected to a corresponding unit, and the plurality of conductive through holes includes a plurality of cross-layer conductive through holes penetrating through the protective layer and the substrate of at least one unit. The present disclosure further relates to a manufacturing method for the semiconductor structure having the stacking unit, and an electric device having the structure.

## Description

### TECHNICAL FIELD

Embodiments of the present disclosure relates to the field of semiconductors, and in particular, to a semiconductor structure and a manufacturing method thereof, and an electronic device having the semiconductor structure.

### BACKGROUND

With rapid development of wireless communication technologies and increasingly extensive application of miniaturized portable terminal apparatus, demand for high-performance and small-size RF front-end modules and devices is increasingly urgent. In recent years, a filter, a diplexer and other filter device based on, for example, a Film Bulk Acoustic Resonator (FBAR), have become more and more popular in the market. This is because on the one hand, they have excellent electrical properties such as low insertion loss, steep transition characteristics, high selectivity, high power capacity, strong electrostatic discharge (ESD) resistance, and on the other hand, they are small in volume and easy to be integrated.

However, there is a need to further reduce a dimension of a filter device.

### SUMMARY

In order to alleviate or solve at least one aspect of the above problems in the related art, the present disclosure is provided.

According to an aspect of embodiments of the present disclosure, there is provided a semiconductor structure with stacked unit. The semiconductor structure includes a protective layer, a plurality of units, and a plurality of conductive through holes. The protective layer has an upper surface and a lower surface. The plurality of units is sequentially stacked on the lower surface of the protective layer along a thickness direction of the protective layer. Each of the plurality of units includes a substrate, a first accommodating space is formed between the protective layer and a substrate of an uppermost unit of the plurality of units, and a second accommodating space is formed between substrates of adjacent stacked upper and lower units of the plurality of units. A substrate of at least one of the plurality of units is provided with a chip that is located in a corresponding one of the first accommodating space and the second accommodating space. Each of the plurality of conductive through holes extends downwardly from the upper surface of the protective layer through the protective layer along the thickness direction of the protective layer to be electrically connected to one of the plurality of units, and the plurality of conductive through holes includes a plurality of cross-layer conductive through holes passing through the protective layer and the substrate of the at least one unit.

An embodiment of the present disclosure further relates to a method of manufacturing a semiconductor structure with stacked units. The method includes: providing a protective layer, the protective layer having a plurality of protective layer through holes penetrating therethrough, and the protective layer having an upper surface and a lower surface; sequentially stacking a plurality of units on the lower surface of the protective layer in a thickness direction of the protective layer, each of the plurality of units including a substrate, a first accommodating space being formed between the protective layer and a substrate of an uppermost unit of the plurality of units, a second accommodating space being formed between substrates of adjacent stacked upper and lower units, and a substrate of at least one of the plurality of units being provided with a chip that is located in a corresponding one of the first accommodating space and the second accommodating space; forming a plurality of connecting through holes between the protective layer and a substrate of the corresponding units, each of the plurality of connecting through holes being coaxially communicated with one of the plurality of protective layer through holes; and filling the plurality of protective layer through holes and the plurality of connecting through holes with a conductive material on a upper surface side of the protective layer to form a plurality of conductive through holes, each of the plurality of conductive through holes being electrically connected to one of the plurality of units, and the plurality of conductive through holes including a plurality of cross-layer conductive through holes passing through the protective layer and the substrate of the at least one unit.

An embodiment of the present disclosure further relates to an electronic device with the semiconductor structure as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic sectional view of an acoustic wave duplexer according to an exemplary embodiment of the present disclosure.
FIGS. 2A to 2F are schematic diagrams illustratively showing a manufacturing process of the acoustic wave diplexer in FIG. 1.
FIG. 2G is a schematic diagram illustratively showing a structure of a conductive metal in a conductive through hole in layers of the acoustic wave duplexer in FIG. 1.
FIG. 3 is a schematic sectional view of an acoustic wave quadplexer according to an exemplary embodiment of the present disclosure.
FIG. 4Ais a schematic diagram illustrating an increased filter power capacity.
FIG. 4B is an exemplary sectional view of an acoustic wave diplexer with an increased filter power capacity.
FIG. 4C is an exemplary sectional view of an acoustic wave quadplexer with an increased filter power capacity.
FIG. 5A is a schematically exemplary diagram of a constituent network of an acoustic wave filter.
FIG. 5B is an exemplary sectional view of an acoustic wave filter according to an embodiment of the present disclosure.
FIG. 5C is a frequency-suppression degree graph illustrating comparison between suppression degrees of the acoustic wave filter in FIG. 5B and a conventional acoustic wave filter.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

In the present disclosure, the semiconductor structure is illustrated by taking an acoustic wave filter as an example. The acoustic wave filter can be electrically connected in a vertical direction in a multi-substrate manner, which can reduce an area of a device, such as a filter, a duplexer, and a quadplexer, by more than 30%. The resonator of the filter will not be limited by processes on the same substrate, thereby improving insertion loss property of the filter.

In the present disclosure, a plurality of resonators of a filter is placed on two or more substrates, and the filter is formed by connecting the plurality of resonators by means of electrical through-hole leads and metal bonding. In the present disclosure, a plurality of filters may be placed on two or more substrates, and the plurality of filters can be combined into a multiplex filter or other device through electrical through-hole leads and metal bonding.

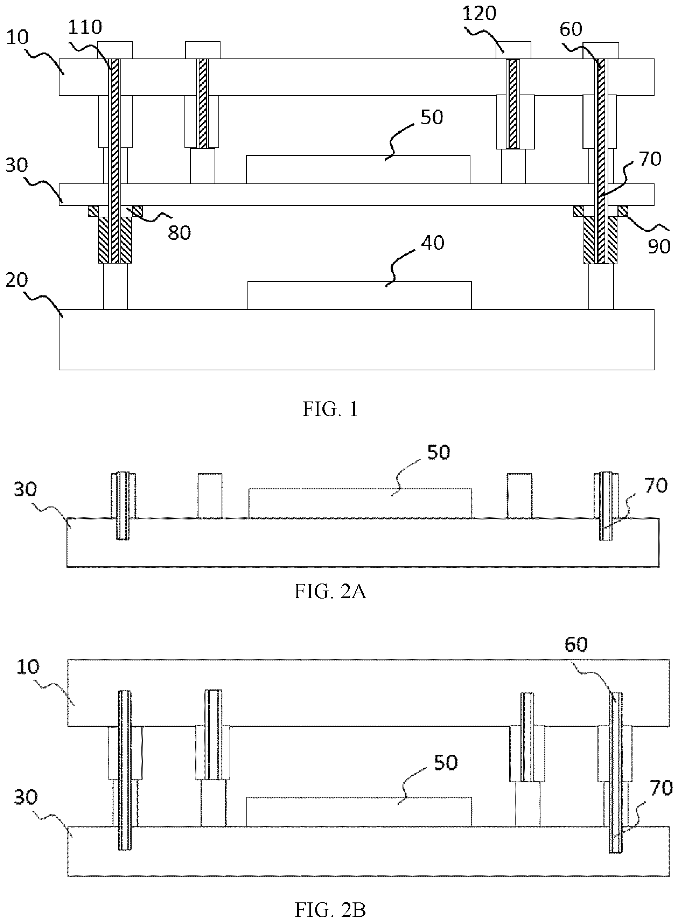

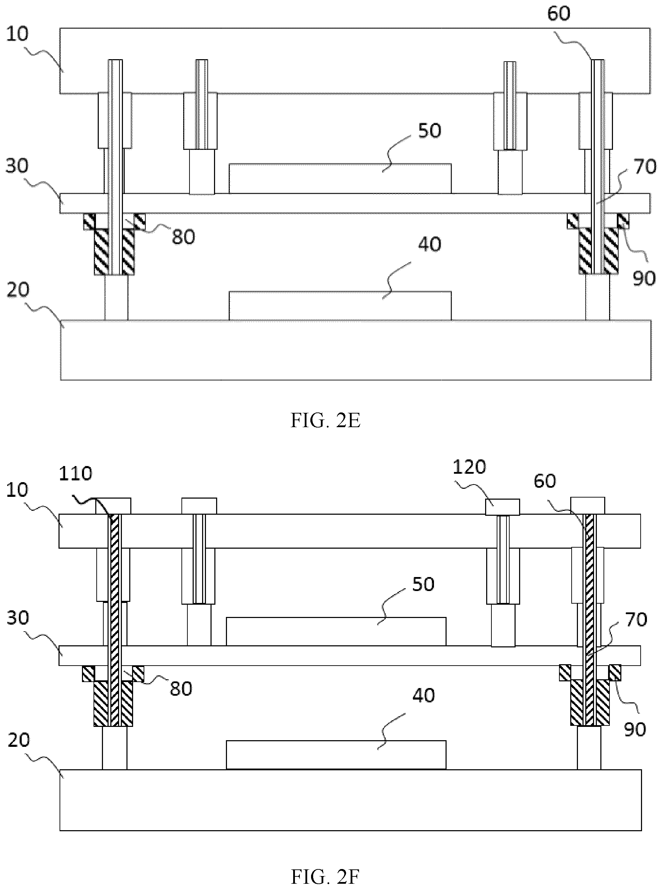

In an embodiment of the present disclosure, electrical input and output are provided on an upper surface of a protective layer or a first substrate 10 (as described later), which is a topmost layer of the semiconductor structure. A lower surface of the corresponding semiconductor structure does not need to be provided with through holes functioning as electrical leads. For example, in FIG. 2F, a substrate 20 located at a lower side of the semiconductor structure is not provided with conductive through holes, but the conductive through holes and conductive pads 120 are provided on the upper surface of the protective layer 10.

Metals that are bonded to each other between adj acent substrates have two functions, one is to ensure electrical connection and the other is to ensure sealing property. A metal bonding structure configured to perform electrical connection is merely shown in the figures of the present disclosure.

In addition, there is no special requirement for a placement orientation of the filters on the substrates. The filters can be arranged in the same orientation, that is, they are all located on a front or upper surface of the substrate (external electrical leads). Alternatively, the filters can be arranged in different orientations, that is, one or more filters are located on the front or upper surface of the substrate and one or more filters are located on a back or lower surface of the substrate. Filters arranged on a lowermost substrate must be located on the front or upper surface of the substrate.

In the present disclosure, the protective layer 10 is used as an uppermost substrate of the semiconductor structure. For example, as shown in the figures, in the semiconductor structure, upward surfaces of the substrates each are an upper surface, and downward surfaces of the substrate each are a lower surface.

FIG. 1 is a schematic sectional view of an acoustic wave duplexer according to an exemplary embodiment of the present disclosure. In FIG. 1, components indicated by respective reference numerals are described as follows.

10: Protective layer or a protective sealing layer, which may be made of a material such as monocrystalline silicon, gallium arsenide, sapphire, and quartz.

20: First substrate, which may be made of a material such as monocrystalline silicon, gallium arsenide, sapphire, and quartz.

30: Second substrate, which may be made of a material such as monocrystalline silicon, gallium arsenide, sapphire, and quartz.

40: First unit, which is provided on an upper surface of the first substrate, and for example, is a single acoustic wave resonator or an electrical connection structure of a plurality of acoustic wave resonators disposed. The acoustic wave resonator includes, but is not limited to, an acoustic mirror, which may be a cavity, or may employ a Bragg reflection layer or other equivalent forms; a top electrode (an electrode pin) that may be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT and contain the above materials doped with a certain atomic ratio of rare earth element; a top electrode (an electrode pin) that may be made of a material such as molybdenum, ruthenium, gold, aluminum, magnesium, tungsten, copper, titanium, iridium, osmium, chromium, or composites or alloys thereof.

50: Second unit, which is provided on an upper surface of the second substrate, and for example, is a single acoustic wave resonator or an electrical connection structure of a plurality of acoustic wave resonators. The acoustic wave resonator includes, but is not limited to, an acoustic mirror, which may be a cavity, or may employ a Bragg reflection layer or other equivalent forms; a bottom electrode (an electrode pin) that may be made of a material such as molybdenum, ruthenium, gold, aluminum, magnesium, tungsten, copper, titanium, iridium, osmium, chromium, or composites or alloys thereof; a piezoelectric film layer, which may be made of a material such as aluminum nitride, zinc oxide, and PZT and contain the above materials doped with a certain atomic ratio of rare earth element; a top electrode (an electrode pin) that may be made of a material such as molybdenum, ruthenium, gold, aluminum, magnesium, tungsten, copper, titanium, iridium, osmium, chromium, or composites or alloys thereof.

60: Electrical connection hole of the protective layer.

70: Electrical connection hole on the second substrate.

80: Bonding protrusion structure formed on a lower surface of the second substrate. In the present disclosure, a lower surface of the substrate and an upper surface of the substrate where the single acoustic wave resonator or the electrical connection structure of the plurality of acoustic wave resonators is located are respectively an upper side face and a lower side face of the substrate in a thickness direction of the substrate.

90: Bonding metal of the lower surface of the second substrate, which may be made of a material such as molybdenum, ruthenium, gold, aluminum, magnesium, tungsten, copper, titanium, iridium, osmium, chromium, or composites or alloys thereof.

110: Electrical connection metal, which may be made of a material such as molybdenum, ruthenium, gold, aluminum, magnesium, tungsten, copper, titanium, iridium, osmium, chromium, or composites or alloys thereof. As can be understood by those skilled in the art, the connection hole can be formed by filling the connecting holes 60 and 70 with the electrical connection metal 110.

120: External metal pad, which may be made of a material such as molybdenum, ruthenium, gold, aluminum, magnesium, tungsten, copper, titanium, iridium, osmium, chromium, or composites or alloys thereof.

FIG. 1 illustrates a conductive through hole (which is an external through hole in FIG. 1, and is electrically connected to the first unit 40) that passes through the protective layer 10 and the second substrate 30 to be connected with a bonding structure on the first substrate 20, and a conductive through hole (which is an internal through hole in FIG. 1, and is electrically connected to the second unit 50) that passes through the protective layer 10 to be electrically connected to a bonding structure on the second substrate 30.

As shown in FIG. 1, a protective layer bonding structure is provided on a lower surface of the protective layer 10, and is located below the protective layer through hole or electrical connection hole 60. An upper bonding structure of the second substrate is provided on an upper surface of the second substrate 30, and a lower bonding structure of the second substrate is provided on a lower surface of the second substrate 30. An upper bonding structure of the first substrate is provided on an upper surface of the first substrate 20. When the protective layer 10, the second substrate 30 and the first substrate 20 are stacked, respective bonding structures are bonded to each other. As shown in FIG. 1, the conductive through hole or electrical connection metal 110 passes through the corresponding bonding structure until it is electrically connected to a bonding structure on the corresponding substrate, i.e. a substrate where a unit to be electrically connected with the conductive through hole is located. In other words, as can be understood by those skilled in the art, bonding of adjacent layers (including bonding between the protective layer and a unit layer and bonding between unit layers) are realized through a bonding structure between the adjacent layers. In addition, the connecting through hole arranged between the adjacent layers is formed by the bonding structure.

As shown in FIG. 1, an upper end of the conductive through hole is opened or located on an upper surface of the protective layer 10. As shown in FIG. 1, conductive pads 120 are electrically connected with the upper end of a respective one of the conductive through holes on the upper surface of the protective layer 10.

Referring to FIGS. 2A to 2F, a method of forming an acoustic wave diplexer through a vertical stacking process is illustrated.

As shown in FIG. 2A, a receiving filter is provided on the second substrate 30, and a connecting hole 70 is provided at a positon corresponding to the second unit 50 and configured to lead out an electric signal of a transmitting filter.

As shown in FIG. 2B, the structure in FIG. 2A is bonded to the protective layer 10 through a first bonding operation. As shown in FIG. 2B, the protective layer 10 is provided with electrical connection holes 60. In FIG. 2B, the external electrical connection hole 60 and the electrical connection hole 70 are coaxially communicated with each other, and the internal electrical connection hole 60 is electrically connected to the bonding structure on the upper surface of the second substrate 30 to be electrically connected to the receiving filter.

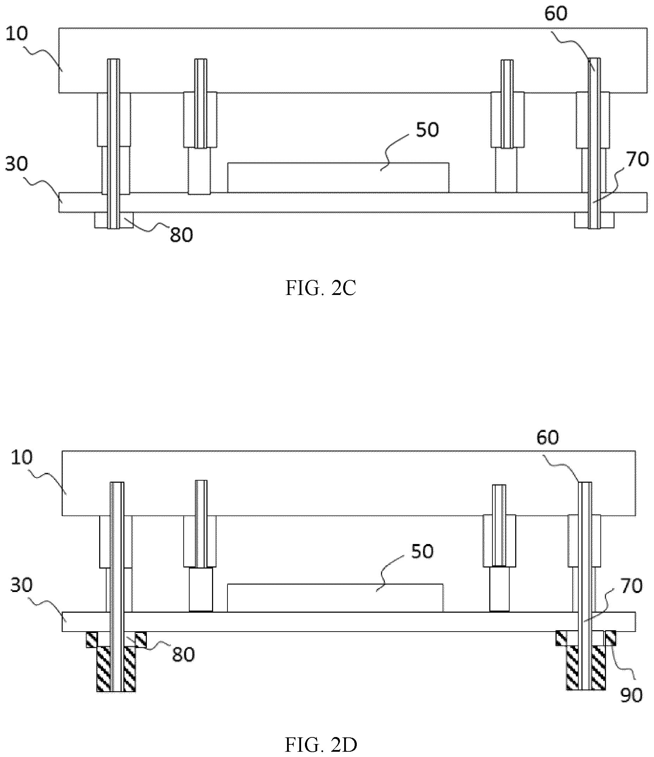

As shown in FIG. 2C, a back surface, i.e. the lower surface, of the second substrate 30 is thinned to form a bonding protrusion structure 80, and this structure can determine a position and dimension of the second bonding without influence of a forming process of the bonding metal. The common patterning of the bonding metal can remove metal outside a mask protection through wet etching. In this process, lateral etching is difficult to be controlled, but this problem can be solved by the protrusion structure 80. As shown in FIG. 2C, the protrusion structures 80 each are a protrusion formed integrally with the thinned second substrate 30, and each of the connecting holes 70 penetrates through one of the protrusion structures 80.

As shown in FIG. 2D, a bonding structure 90 is formed on the lower surface of the second substrate 30, and has a width larger than that of the protrusion structure 80 by 1 µm or more, to ensure that a bonding dimension is defined by the protrusion structure 80. As shown in FIG. 2D, the connection hole 70 extends through the bonding structure 90.

As shown in FIG. 2E, the structure in FIG. 2D is bonded to the first substrate 20 that is provided with the transmitting filter corresponding to the first unit 40. The electrical connection hole 60 of the protective layer 10 and the electrical connection hole 70 on the second substrate 30 are coaxially communicated with each other.

As shown in FIG. 2F, the protective layer 10 is thinned from the upper surface of the protective layer 10 to expose the electrical connection hole 60 of the protective layer 10, such that the connection hole 60 penetrates through the protective layer 10. The electrical connection hole 60 of the protective layer 10 and the electrical connection hole 70 of the second substrate 30 are communicated with each other. An effective electrical connection (i.e., a conductive through hole) is formed in the electrical connection hole 60 of the protective layer 10 and the electrical connection hole 70 of the second substrate 30 through one electroplating process. This one-time filling of the electrical connection holes 60, 70 can effectively solve or alleviate problems of poor bonding effect in a second bonding and poor sealing performance caused by separate filling of the electrical connection holes 70. Meanwhile, it provides good electrical conduction property and processing steps can be saved. Finally, metal pads 120 are formed.

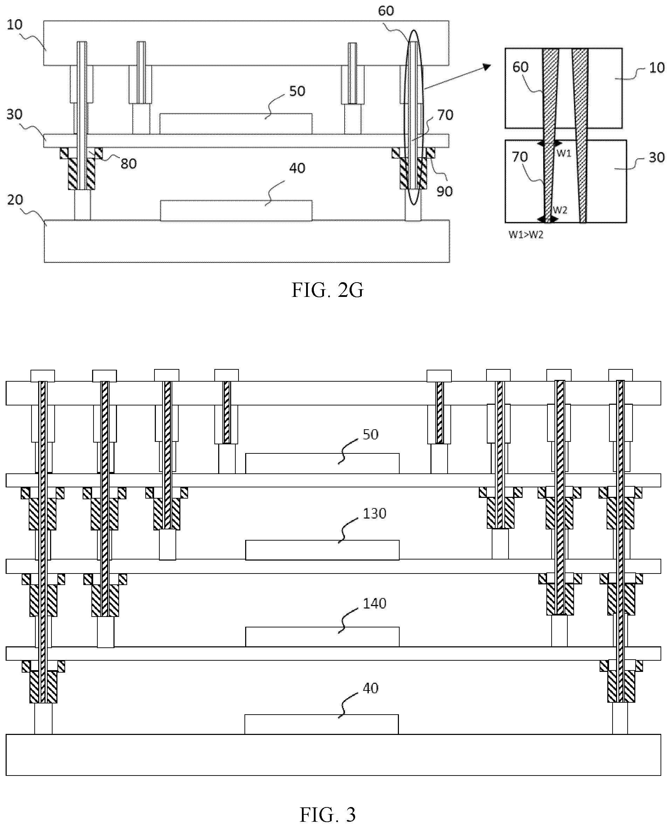

FIG. 2G is a schematic diagram illustratively showing a structure of a conductive metal in a cross-layer conductive through hole of the acoustic wave duplexer in FIG. 1. As shown in FIG. 2G, based on one-time filling molding, a wall thickness of a conductive metal pillar in the through hole is gradually decreased from top to bottom.

In the present disclosure, the integrally molding of the conductive pillar means that the conductive pillar is integrally molded based on one-time filling of conductive materials, instead of filling two conductive through holes separately and then performing a bonding operation to communicate the two conductive through holes with each other. Because the conductive pillar is integrally molded, problems that holes, virtual connections, contamination defects and the like are easy to be formed at two metal-filling contacts caused by the bonding operation do not exist at the conductive pillars in the present disclosure.

FIG. 3 is a schematic sectional view of an acoustic wave quadplexer according to an exemplary embodiment of the present disclosure.

The processes in FIGS. 2B to 2E can be repeated three times prior to a process shown in FIG. 2F. Specifically, the middle three substrates are thinned, the protective layer is thinned, and finally the lowermost substrate, such as the first substrate 20, is thinned.

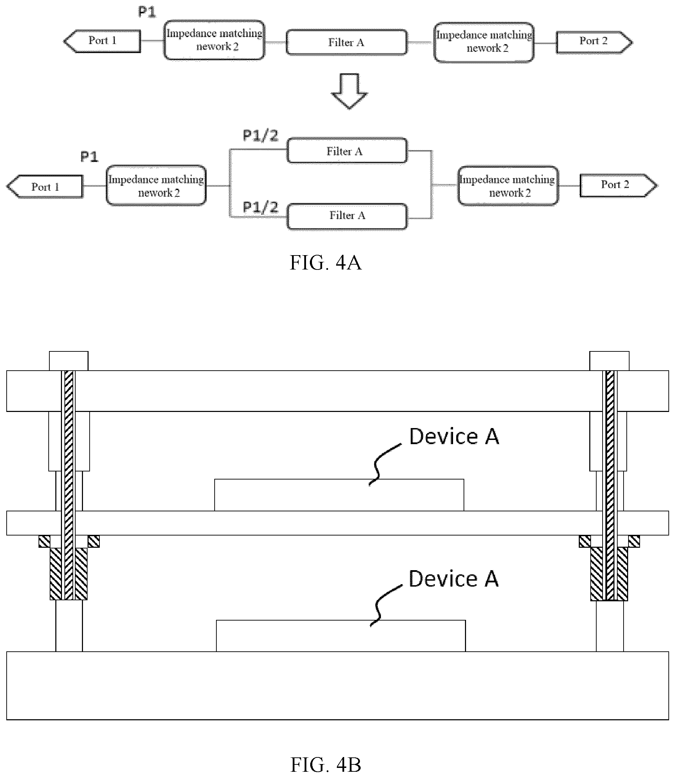

FIG. 4A is a schematic diagram illustrating an increased filter power capacity. As shown in FIG. 4A, two identical filters A (Device A) are arranged in parallel, energy passing through either of the filters can be reduced by half, and the power capacity of the filters can be about doubled. Similarly, if N identical filters are connected in parallel, the power capacity of the filters can be increased to about N times that of a single filter.

FIG. 4B is an exemplary sectional view of an acoustic wave diplexer with an increased filter power capacity. In a traditional method, if one same filter is added, a whole area may be twice as large as an original one. The vertical stacking method can increase the power capacity without increasing the area. As shown in FIG. 4B, since the conductive pads of a lowermost filter are shared with a middle filter, the area does not change while the power capacity is increased to about 2 times.

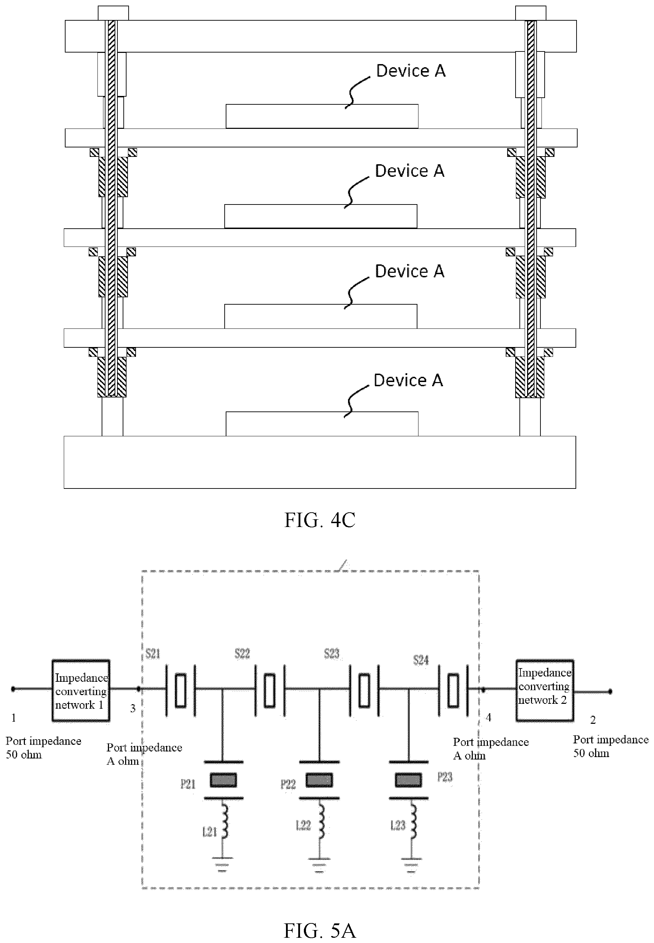

FIG. 4C is an exemplary sectional view of an acoustic wave quadplexer with an increased filter power capacity. As shown in FIG. 4C, four identical filters are connected in parallel. Since all of the filters share a conductive pad, the area is unchanged while the power capacity is increased to about 4 times. Similarly, if the requirements such as limitation on a height of the filter are satisfied, the power capacity can be continually increased with this method.

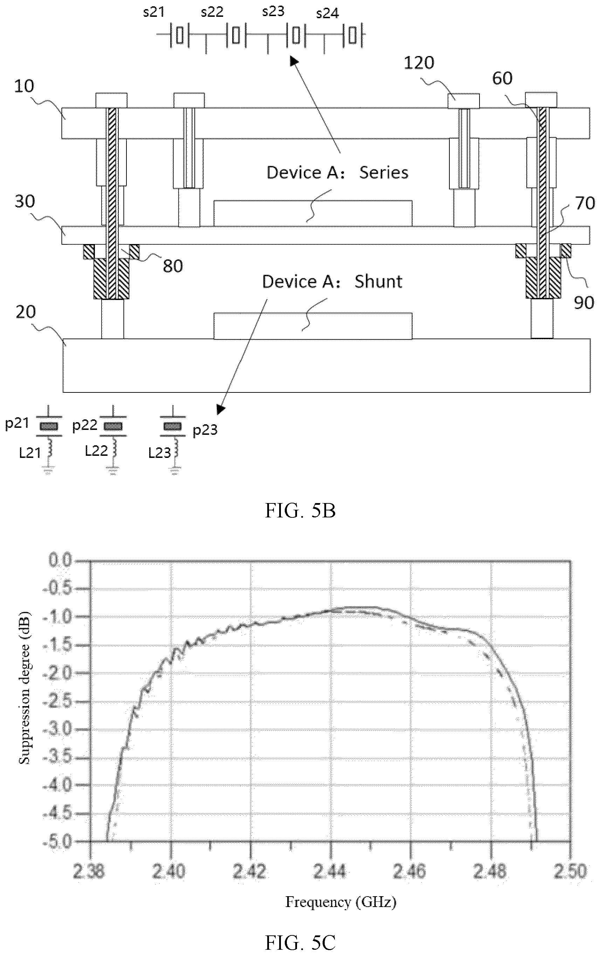

FIG. 5A is an exemplary diagram of a constituent network of an acoustic wave filter, FIG. 5B is an exemplary sectional view of an acoustic wave filter according to an embodiment of the present disclosure, and FIG. 5C is a frequency-suppression degree graph illustrating comparison between suppression degrees of the acoustic wave filter in FIG. 5B and a conventional acoustic wave filter.

FIG. 5A shows a constituent network of an acoustic wave filter. According to a traditional manufacturing method, series resonators S21, S22, S23, S24 and parallel resonators P21, P22, P23 are formed on the same substrate. Thicknesses of the bottom electrode, the piezoelectric layer and the top electrode of series and parallel resonators are the same due to limitation on cost and process complexity. A selective mass loading layer is provided such that the series resonant frequency is different from the parallel resonant frequency, thereby achieving filtering effect.

As shown in FIG. 5B, the series resonator is formed on a middle substrate and the parallel resonator is formed on a lower substrate, so that thicknesses of the series and parallel resonators are different and can be optimized separately. Specifically, a thickness of at least one of the top electrode, the piezoelectric layer, the bottom electrode and a passivation layer of the series resonator of a same filter is different from a thicknesses of a corresponding one of the top electrode, the piezoelectric layer, the bottom electrode and the passivation layer of the parallel resonator of the same filter. It should be noted that the "passivation layer" herein does not mean that the resonator must have a passivation layer, but that a thickness of the passivation layer of the series resonator can be different from that of the parallel resonator when the resonator has the passivation layer.

In FIG. 5B, "Device A: series" indicates that a resonator A is connected in series, and "Device A: Shunt" indicates that the resonator A is connected in parallel. The optimization effect is shown in FIG. 5C, in which a dotted line represents a suppression degree curve of a traditional filter, and a solid line represents a suppression degree curve of the structure of FIG. 5B. It can be seen that suppression degree at a right side of a passband is obviously improved for the solid line.

It should be noted that all of series resonators of a filter need to be arranged on a same substrate, and in this way, it can be ensured that electrical impedance between series resonators is as small as possible and deterioration of filter insertion loss can be avoided. Parallel resonators of the filter can be arranged on different substrates.

In view of the above, the present disclosure provides following technical solutions.
1. A semiconductor structure with stacked units includes:
   a protective layer having an upper surface and a lower surface;
   a plurality of units sequentially stacked on the lower surface of the protective layer along a thickness direction of the protective layer, each of the plurality of units including a substrate, a first accommodating space being formed between the protective layer and a substrate of an uppermost unit of the plurality of units, a second accommodating space being formed between substrates of adjacent stacked upper and lower units of the plurality of units, and a substrate of at least one of the plurality of units being provided with a chip that is located in a corresponding one of the first accommodating space and the second accommodating space; and
   a plurality of conductive through holes, each of the plurality of conductive through holes extending downwardly from the upper surface of the protective layer through the protective layer along the thickness direction of the protective layer to be electrically connected to one of the plurality of units, and the plurality of conductive through holes including a plurality of cross-layer conductive through holes passing through the protective layer and the substrate of the at least one unit.
2. The semiconductor structure according to 1, wherein
   the plurality of conductive through holes includes a plurality of cross-layer conductive through holes that passes through a substrate of the upper unit to be electrically connected to the lower unit, and/or a plurality of cross-layer conductive through holes that passes through substrates of the upper unit and the lower unit to be electrically connected to a corresponding unit of the plurality of units located below the lower unit.
3. The semiconductor structure according to 2, wherein
   one of the adjacent stacked upper and lower units is a series resonator unit including a plurality of series resonators, and the other of the adjacent stacked upper and lower units is a parallel resonator unit including a plurality of parallel resonators; and
   the plurality of conductive through holes includes conductive through holes electrically connected with the series resonator unit and conductive through holes electrically connected with the parallel resonator unit.
4. The semiconductor structure according to 3, wherein
   at least one of a piezoelectric layer, a top electrode, a bottom electrode and a passivation layer of the series resonator has a thicknesses different from a thicknesses of a corresponding one of a piezoelectric layer, a top electrode, a bottom electrode and a passivation layer of the parallel resonator.
5. The semiconductor structure according to 2, wherein
   one of the adjacent stacked upper and lower units is a receiving filter unit, and the other of the adjacent stacked upper and lower units is a transmitting filter unit.
6. The semiconductor structure according to 1, wherein
   the plurality of conductive through holes includes single-layer conductive through holes that pass through the protective layer to be electrically connected to the uppermost unit.
7. The semiconductor structure according to any one of 1 to 6, wherein
   each of the plurality of cross-layer conductive through holes is electrically connected to a corresponding unit of the plurality of units located below the protective layer.
8. The semiconductor structure according to 7, wherein
   the plurality of units merely includes a first unit and a second unit that are sequentially stacked from top to bottom; and
   each of the plurality of cross-layer conductive through holes is merely electrically connected to the second unit.
9. The semiconductor structure according to 7, wherein
   the plurality of units merely includes a first unit, a second unit, a third unit, and a fourth unit that are sequentially stacked from top to bottom; and
   the plurality of cross-layer conductive through holes includes cross-layer conductive through holes merely electrically connected with the second unit, cross-layer conductive through holes merely electrically connected with the third unit, and cross-layer conductive through holes merely electrically connected with the fourth unit.
10. The semiconductor structure according to 1, wherein
   at least one of the plurality of cross-layer conductive through holes is electrically connected to at least two of the plurality of units.
11. The semiconductor structure according to 10, wherein
   each of the plurality of conductive through holes is a cross-layer conductive through hole electrically connected to all of the plurality of units.
12. The semiconductor structure according to 11, wherein
   the plurality of units merely includes four identical units that are sequentially stacked from top to bottom, and each of the four identical units is a filter unit; or
   the plurality of units merely includes two identical units that are sequentially stacked from top to bottom, and each of the two identical units is a filter unit.
13. The semiconductor structure according to 1, wherein
   each of the plurality of units is arranged on an upper surface of a corresponding one of the substrates.
14. The semiconductor structure according to 1, wherein
   for two units of the plurality of units that are adjacent to each other in a thickness direction of the semiconductor structure, a conductive through hole electrically connected with the upper unit of the two units is located at an inner side of a conductive through hole electrically connected with the lower unit of the two units in a radial direction.
15. The semiconductor structure according to 1, wherein
   the semiconductor structure includes at least one filter, series resonators of a same one of the at least one filter being arranged on one substrate of the substrates, and parallel resonators of a same one of the at least one filter being arranged on another substrate of the substrates that is different from the one substrate.
16. The semiconductor structure according to 1, wherein
   the semiconductor structure includes at least one filter, a thickness of at least one of a top electrode, a piezoelectric layer, a bottom electrode and a passivation layer of a series resonator of a same one of the at least one filter being different from a thicknesses of a corresponding one of a top electrode, a piezoelectric layer, a bottom electrode and a passivation layer of a parallel resonator of a same one of the at least one filter.
17. The semiconductor structure according to any one of 1 to 16, wherein
   the semiconductor structure further includes conductive pads provided on the upper surface of the protective layer, and the conductive pads are electrically connected to the plurality of conductive through hole in one-to-one correspondence.
18. The semiconductor structure according to any one of 1 to 16, wherein
   each of the plurality of cross-layer conductive through holes is provided with a conductive pillar, and the conductive pillar is an integrally molded conductive pillar.
19. The semiconductor structure according to 18, wherein
   the integrally molded conductive pillar is a conductive pillar having a wall thickness gradually decreasing from top to bottom.
20. A method of manufacturing a semiconductor structure with stacked units includes:
   providing a protective layer, the protective layer having a plurality of protective layer through holes penetrating therethrough, and the protective layer having an upper surface and a lower surface;
   sequentially stacking a plurality of units on the lower surface of the protective layer in a thickness direction of the protective layer, each of the plurality of units including a substrate, a first accommodating space being formed between the protective layer and a substrate of an uppermost unit of the plurality of units, a second accommodating space being formed between substrates of adjacent stacked upper and lower units, and a substrate of at least one of the plurality of units being provided with a chip that is located in a corresponding one of the first accommodating space and the second accommodating space;
   forming a plurality of connecting through holes between the protective layer and a substrate of the corresponding units, each of the plurality of connecting through holes being coaxially communicated with one of the plurality of protective layer through holes; and
   filling the plurality of protective layer through holes and the plurality of connecting through holes with a conductive material on a upper surface side of the protective layer to form a plurality of conductive through holes, each of the plurality of conductive through holes being electrically connected to one of the plurality of units, and the plurality of conductive through holes including a plurality of cross-layer conductive through holes passing through the protective layer and the substrate of the at least one unit.
21. The method according to 20, wherein
   in the providing the protective layer, the protective layer is provided with protective layer holes extending from the lower surface of the protective layer into a part of a thickness of the protective layer; and
   the method further includes etching the upper surface of the protective layer to expose the plurality of protective layer holes, such that the plurality of protective layer holes each is a protective layer through hole.
22. The method according to 20 or 21, wherein
   the plurality of conductive through holes includes cross-layer conductive through holes that pass through the upper unit to be electrically connected to the lower unit or cross-layer conductive through holes that pass through the substrate of the lower unit to be electrically connected to a unit of the plurality of units located below the lower unit.
23. The method according to 20, wherein
   the semiconductor structure includes at least one filter, and the method further includes arranging series resonators of a same filter of the at least one filter on one substrate of the substrates and arranging parallel resonators of a same filter of the at least one filter on another substrate of the substrates different from the one substrate.
24. The method according to 20, wherein
   the semiconductor structure includes at least one filter, and the method further includes configuring a thickness of at least one of a top electrode, a piezoelectric layer, a bottom electrode and a passivation layer of a series resonator of a same one of the at least one filter to be different from a thicknesses of a corresponding one of a top electrode, a piezoelectric layer, a bottom electrode and a passivation layer of a parallel resonator of a same one of the at least one filter.
25. The method according to any one of 20 to 24, wherein
   in the forming the plurality of conductive through holes, a metal pillar in each of the cross-layer conductive through holes is an integrally molded conductive pillar.
26. The method according to 25, wherein
   the integrally molded conductive pillar is a conductive pillar, and the conductive pillar has a wall thickness gradually decreasing from top to bottom.
27. An electronic device includes the semiconductor structure according to any one of 1 to 19 or the semiconductor structure manufactured according to the method according to any one of 20 to 26.

In the present disclosure, the semiconductor structure may be a filter, for example, as shown in FIG. 5B. It can be a duplexer, for example, as shown in FIG. 1. It can be a quadplexer, for example, as shown in FIG. 3. As can be understood, the semiconductor structure can be other structures based on chips with different unit configurations. In the present disclosure, the chip may include a semiconductor device, such as a microelectromechanical device, an active or passive semiconductor device or the like.

The electronic apparatus herein includes, but is not limited to, an intermediate product such as an RF front end, a filtering and amplifying module; and a terminal product such as a mobile phone, WIFI and a drone.

In the present disclosure, the cross-layer conductive through holes pass through the substrate of at least one unit to be electrically connected with another unit in stacked chips. The single-layer conductive through hole is only electrically connected with the uppermost unit.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A semiconductor structure with stacked units, comprising:
a protective layer having an upper surface and a lower surface;
a plurality of units sequentially stacked on the lower surface of the protective layer along a thickness direction of the protective layer, each of the plurality of units comprising a substrate, a first accommodating space being formed between the protective layer and a substrate of an uppermost unit of the plurality of units, a second accommodating space being formed between substrates of adjacent stacked upper and lower units of the plurality of units, and a substrate of at least one of the plurality of units being provided with a chip that is located in a corresponding one of the first accommodating space and the second accommodating space; and
a plurality of conductive through holes, each of the plurality of conductive through holes extending downwardly from the upper surface of the protective layer through the protective layer along the thickness direction of the protective layer to be electrically connected to one of the plurality of units, and the plurality of conductive through holes comprising a plurality of cross-layer conductive through holes passing through the protective layer and the substrate of the at least one unit.

2. The semiconductor structure according to claim 1, wherein the plurality of conductive through holes comprises a plurality of cross-layer conductive through holes that passes through a substrate of the upper unit to be electrically connected to the lower unit, and/or a plurality of cross-layer conductive through holes that passes through substrates of the upper unit and the lower unit to be electrically connected to a corresponding unit of the plurality of units located below the lower unit.

3. The semiconductor structure according to claim 2, wherein one of the adjacent stacked upper and lower units is a series resonator unit comprising a plurality of series resonators, and the other of the adjacent stacked upper and lower units is a parallel resonator unit comprising a plurality of parallel resonators; and
the plurality of conductive through holes comprises conductive through holes electrically connected with the series resonator unit and conductive through holes electrically connected with the parallel resonator unit.

4. The semiconductor structure according to claim 3, wherein at least one of a piezoelectric layer, a top electrode, a bottom electrode and a passivation layer of the series resonator has a thicknesses different from a thicknesses of a corresponding one of a piezoelectric layer, a top electrode, a bottom electrode and a passivation layer of the parallel resonator.

5. The semiconductor structure according to claim 2, wherein one of the adjacent stacked upper and lower units is a receiving filter unit, and the other of the adjacent stacked upper and lower units is a transmitting filter unit.

6. The semiconductor structure according to claim 1, wherein the plurality of conductive through holes comprises single-layer conductive through holes that pass through the protective layer to be electrically connected to the uppermost unit.

7. The semiconductor structure according to any one of claims 1 to 6, wherein each of the plurality of cross-layer conductive through holes is electrically connected to a corresponding unit of the plurality of units located below the protective layer.

8. The semiconductor structure according to claim 7, wherein the plurality of units comprises a first unit and a second unit that are sequentially stacked from top to bottom; and
each of the plurality of cross-layer conductive through holes is electrically connected to the second unit.

9. The semiconductor structure according to claim 7, wherein the plurality of units comprises a first unit, a second unit, a third unit, and a fourth unit that are sequentially stacked from top to bottom; and
the plurality of cross-layer conductive through holes comprises cross-layer conductive through holes merely electrically connected with the second unit, cross-layer conductive through holes merely electrically connected with the third unit, and cross-layer conductive through holes merely electrically connected with the fourth unit.

10. The semiconductor structure according to claim 1, wherein at least one of the plurality of cross-layer conductive through holes is electrically connected to at least two of the plurality of units.

11. The semiconductor structure according to claim 10, wherein each of the plurality of conductive through holes is a cross-layer conductive through hole electrically connected to all of the plurality of units.

12. The semiconductor structure according to claim 11, wherein the plurality of units comprises four identical units that are sequentially stacked from top to bottom, and each of the four identical units is a filter unit; or
the plurality of units comprises two identical units that are sequentially stacked from top to bottom, and each of the two identical units is a filter unit.

13. The semiconductor structure according to claim 1, wherein each of the plurality of units is arranged on an upper surface of a corresponding one of the substrates.

14. The semiconductor structure according to claim 1, wherein for two units of the plurality of units that are adjacent to each other in a thickness direction of the semiconductor structure, a conductive through hole electrically connected with the upper unit of the two units is located at an inner side of a conductive through hole electrically connected with the lower unit of the two units in a radial direction.

15. The semiconductor structure according to claim 1, further comprising:
at least one filter, series resonators of a same one of the at least one filter being arranged on one substrate of the substrates, and parallel resonators of a same one of the at least one filter being arranged on another substrate of the substrates that is different from the one substrate.

16. The semiconductor structure according to claim 1, further comprising:
at least one filter, a thickness of at least one of a top electrode, a piezoelectric layer, a bottom electrode and a passivation layer of a series resonator of a same one of the at least one filter being different from a thicknesses of a corresponding one of a top electrode, a piezoelectric layer, a bottom electrode and a passivation layer of a parallel resonator of a same one of the at least one filter.

17. The semiconductor structure according to any one of claims 1 to 16, further comprising:
conductive pads provided on the upper surface of the protective layer, the conductive pads being electrically connected to the plurality of conductive through hole in one-to-one correspondence.

18. The semiconductor structure according to any one of claims 1 to 16, wherein each of the plurality of cross-layer conductive through holes is provided with a conductive pillar, and the conductive pillar is an integrally molded conductive pillar.

19. The semiconductor structure according to claim 18, wherein the integrally molded conductive pillar is a conductive pillar having a wall thickness gradually decreasing from top to bottom.

20. A method of manufacturing a semiconductor structure with stacked units, comprising:
providing a protective layer, the protective layer having a plurality of protective layer through holes penetrating therethrough, and the protective layer having an upper surface and a lower surface;
sequentially stacking a plurality of units on the lower surface of the protective layer in a thickness direction of the protective layer, each of the plurality of units comprising a substrate, a first accommodating space being formed between the protective layer and a substrate of an uppermost unit of the plurality of units, a second accommodating space being formed between substrates of adjacent stacked upper and lower units, and a substrate of at least one of the plurality of units being provided with a chip that is located in a corresponding one of the first accommodating space and the second accommodating space;
forming a plurality of connecting through holes between the protective layer and a substrate of the corresponding units, each of the plurality of connecting through holes being coaxially communicated with one of the plurality of protective layer through holes; and
filling the plurality of protective layer through holes and the plurality of connecting through holes with a conductive material on a upper surface side of the protective layer to form a plurality of conductive through holes, each of the plurality of conductive through holes being electrically connected to one of the plurality of units, and the plurality of conductive through holes comprising a plurality of cross-layer conductive through holes passing through the protective layer and the substrate of the at least one unit.

21. The method according to claim 20, wherein in the providing the protective layer, the protective layer is provided with protective layer holes extending from the lower surface of the protective layer into a part of a thickness of the protective layer; and
the method further comprises etching the upper surface of the protective layer to expose the plurality of protective layer holes, such that the plurality of protective layer holes each is a protective layer through hole.

22. The method according to claim 20 or 21, wherein the plurality of conductive through holes comprises cross-layer conductive through holes that pass through the upper unit to be electrically connected to the lower unit or cross-layer conductive through holes that pass through the substrate of the lower unit to be electrically connected to a unit of the plurality of units located below the lower unit.

23. The method according to claim 20, wherein the semiconductor structure comprises at least one filter, and the method further comprises:
arranging series resonators of a same filter of the at least one filter on one substrate of the substrates and arranging parallel resonators of a same filter of the at least one filter on another substrate of the substrates different from the one substrate.

24. The method according to claim 20, wherein the semiconductor structure comprises at least one filter, and the method further comprises:
configuring a thickness of at least one of a top electrode, a piezoelectric layer, a bottom electrode and a passivation layer of a series resonator of a same one of the at least one filter to be different from a thicknesses of a corresponding one of a top electrode, a piezoelectric layer, a bottom electrode and a passivation layer of a parallel resonator of a same one of the at least one filter.

25. The method according to any one of claims 20 to 24, wherein in the forming the plurality of conductive through holes, a metal pillar in each of the cross-layer conductive through holes is an integrally molded conductive pillar.

26. The method according to claim 25, wherein the integrally molded conductive pillar is a conductive pillar, and the conductive pillar has a wall thickness gradually decreasing from top to bottom.

27. An electronic device, comprising the semiconductor structure according to any one of 1 to 19 or the semiconductor structure manufactured according to the method according to any one of 20 to 26.
